(19)

**Europäisches Patentamt**
**European Patent Office**
**Office européen des brevets**

(11) **EP 4 650 965 A2**

(12) **EUROPEAN PATENT APPLICATION**

(43) Date of publication:
**19.11.2025 Bulletin 2025/47**

(21) Application number: **25176973.3**

(22) Date of filing: **16.05.2025**

(51) International Patent Classification (IPC):
**G06F 11/10** (2006.01)

(52) Cooperative Patent Classification (CPC):
**G06F 11/1076**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **17.05.2024 US 202463649132 P**

(71) Applicant: **Kioxia Corporation**
**Tokyo 105-8001 (JP)**

(72) Inventors:
• **RAI, Devesh Kumar**
  **Minato-ku, Toyko, 105-8001 (JP)**
• **SALUJA, Mohinder Kumar**
  **Minato-ku, Toyko, 105-8001 (JP)**

(74) Representative: **Hoffmann Eitle**
**Patent- und Rechtsanwälte PartmbB**
**Arabellastraße 30**
**81925 München (DE)**

(54) **NON-VOLATILE STORAGE DEVICE OFFLOADING IN A MULTI-DATA NODE ENVIRONMENT**

(57) Various examples, controllers and methods are disclosed relating to parity checking. One controller can receive a plurality of data segments from a compute node via an interface. Further, the controller can determine at least one intermediate parity based on performing at least one XOR operation of the plurality of data segments, the at least one intermediate parity being stored in at least one device buffer of the first storage device. Further, the controller can transmit the at least one intermediate parity of the at least one device buffer to at least one parity storage device, wherein the at least one intermediate parity corresponds to one of a plurality of intermediate parities used to determine at least one partial parity of a redundant array of independent disk (RAID) volume. Further, the controller can store the plurality of data segments in at least the first storage device and a second storage device.

FIG. 2

**Description**

## TECHNICAL FIELD

The present disclosure generally relates to systems, methods, and non-transitory processor-readable media for data processing using multiple non-volatile memory devices.

## BACKGROUND

A general system that provides data storage can include a compute node or host coupled to multiple non-volatile memory devices via one or more interfaces. The compute node can include a processing unit such as a Central Processing Unit (CPU) coupled to a memory unit such as a Dynamic Random Access Memory (DRAM). The CPU can be coupled to the one or more interfaces via a root complex. Redundant Array of Independent Disks (RAID) can be implemented on the non-volatile memory devices to achieve protection from drive failures.

## BRIEF SUMMARY

Some implementations relate to a first storage device including a first non-volatile memory and a controller. The controller can be configured to receive a plurality of data segments from a compute node via an interface. Further, the controller can be configured to determine at least one intermediate parity based on performing at least one XOR operation of the plurality of data segments, the at least one intermediate parity being stored in at least one device buffer of the first storage device. Further, the controller can be configured to transmit the at least one intermediate parity of the at least one device buffer to at least one parity storage device, wherein the at least one intermediate parity corresponds to one of a plurality of intermediate parities used to determine at least one partial parity of a redundant array of independent disk (RAID) volume. Further, the controller can be configured to store the plurality of data segments in at least the first storage device and a second storage device.

Some implementations relate to a first parity storage device including a non-volatile memory and a controller. The controller can be configured to receive a plurality of data segments from a compute node via an interface. Further, the controller can be configured to determine a first intermediate parity based on performing a first XOR operation of the plurality of data segments, the first intermediate parity being stored in at least one device buffer of the first parity storage device. Further, the controller can be configured to determine a second intermediate parity based on performing a second XOR operation of the plurality of data segments, the second intermediate parity being stored in the at least one device buffer of the first parity storage device. Further, the controller can be configured to transmit the second intermediate parity of the at least one device buffer to a second parity storage device. Further, the controller can be configured to store the plurality of data segments in at least a first storage device and a second storage device. Further, the controller can be configured to receive at least one third intermediate parity from at least one third storage device of a redundant array of independent disk (RAID) volume, the at least one third intermediate parity corresponds to at least the first intermediate parity. Further, the controller can be configured to determine at least one partial parity based on performing at least one XOR operation of at least the first intermediate parity and the at least one third intermediate parity. Further, the controller can be configured to store the at least one partial parity in the non-volatile memory, the at least one partial parity corresponds to a set of data segments.

## BRIEF DESCRIPTION OF THE DRAWINGS

Various objects, aspects, features, and advantages of the disclosure will become more apparent and better understood by referring to the detailed description taken in conjunction with the accompanying drawings, in which like reference characters identify corresponding elements throughout. In the drawings, like reference numbers indicate identical, functionally similar, and/or structurally similar elements.

FIG. 1 is a block diagram illustrating an example system including data nodes and a compute node, according to some implementations.

FIG. 2 is a block diagram further illustrating the example system including non-volatile memory devices and the data nodes, according to some implementations.

FIG. 3A is a block diagram illustrating an example method for performing offloading, according to some implementations.

FIG. 3B is a block diagram illustrating an example method for performing one or more parity checks on a data node using a controller of a storage device, according to some implementations.

FIG. 3C is a block diagram illustrating an example method for performing one or more parity checks across data nodes using a controller of a storage device, according to some implementations.

FIG. 3D is a flowchart illustrating an example method for performing operations on data segments, according to some implementations.

It will be recognized that some or all of the figures are schematic representations for purposes of illustration. The figures are provided for the purpose of illustrating one or more implementations with the explicit understanding that they will not be used to limit the scope of the meaning the claims.

## DETAILED DESCRIPTION

This disclosure relates to systems and methods for offloading operations including parity checking of data segments. Often, during data segments can be transferred to and from SSDs in a RAID group or array. That is, during when a write operations occurs on RAID systems, such as RAID 5 or RAID 6, the write process often includes performing parity checks. Typically, as the RAID system reads all data and associated parity from the disks, a host or compute node can recalculate the parity for the data blocks being read and compare it against the stored parity. This step constitutes a parity check. However, performing parity checks by hosts or compute nodes can be resource-intensive and slow down system performance. That is, handling large volumes of data and parity calculations demand significant processing power and bandwidth, which can impact the overall system efficiency and throughput. Accordingly, the systems and methods described in the various implementations herein provide improvements by reducing the computational load on primary processors and enhancing data throughput. The parity checking described herein decreases and/or eliminates the CPU usage for segment passes and DRAM bandwidth, while varying the load on PCIe and network segments to improve system resources. That is, the systems and methods provide granular implementations to RAID offloading, maintaining data integrity by addressing discrepancies in both data and parity segments during RAID operations.

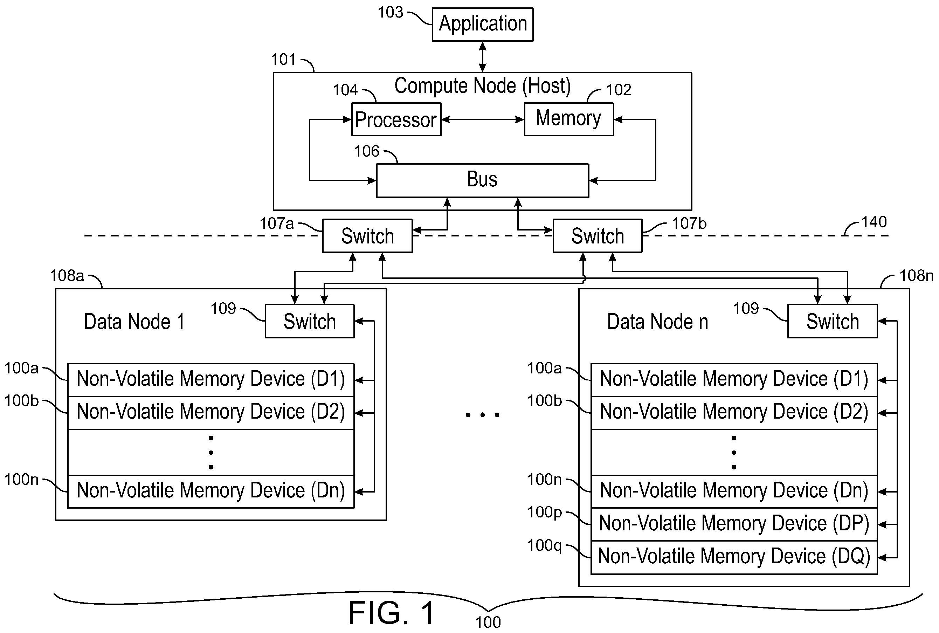

Referring now to FIG. 1, a block diagram illustrating an example system including data nodes and a compute node, according to some implementations. To assist in illustrating the present implementations, FIG. 1 shows a block diagram of a system including non-volatile memory devices 100a, ... , 100n (collectively, "non-volatile memory devices 100") coupled to a compute node 101 (or host 101) according to some examples. The compute node 101 can be a user device operated by a user or an autonomous central controller of the non-volatile memory devices 100, where the compute node 101 and non-volatile memory devices 100 correspond to a storage subsystem or storage appliance. The compute node 101 can be connected to an application 103 (e.g., via a network interface) such that applications or other compute node (host) computers (not shown) may access the storage subsystem or storage appliance via a communication network. Examples of such a storage subsystem or appliance include an All Flash Array (AFA) or a Network Attached Storage (NAS) device. As shown, the compute node 101 includes a memory 102, a processor 104, and a bus 106. The processor 104 is operatively coupled to both the memory 102 and the bus 106. In some implementations, the processor 104 and the memory 102 are operatively coupled to the bus 106 through a root complex (e.g., PCIe root complex). The processor 104 is sometimes referred to as a Central Processing Unit (CPU) of the compute node 101, and configured to perform processes of the compute node 101.

The memory 102 is a local memory of the compute node 101. In some examples, the memory 102 is or a buffer, sometimes referred to as a host buffer. In some examples, the memory 102 is a volatile storage. In other examples, the memory 102 is a non-volatile persistent storage. Examples of the memory 102 include but are not limited to, Random Access Memory (RAM), Dynamic Random Access Memory (DRAM), Static RAM (SRAM), Magnetic RAM (MRAM), Phase Change Memory (PCM), and so on. In some implementations, the compute node 101 can be communicably coupled to an external host that includes application 103. This host may be distinct from the compute node 101 and serves as an interface for managing and processing data requests from application 103. By this implementation, the external host can access the storage subsystem or appliance managed by the compute node 101, facilitating data interactions for application 103 operations.

The bus 106 includes one or more of software, firmware, and hardware that provide an interface through components of the compute node 101 can communicate. Examples of components include but are not limited to, the processor 104, network cards, storage devices, the memory 102, graphic cards, and so on. In addition, the compute node 101 (e.g., the processor 104) can communicate with the non-volatile memory devices 100 of data nodes 108a, ..., 108n using the bus 106. In some examples, the non-volatile memory devices 100 are attached or communicably coupled to the bus 106 over a suitable interface 140.

In some implementations, the suitable interface 140 may be switches 107a and 107b (collectively referred to herein as "switches 107"). For example, switch 107a and/or switch 107b may be a PCIe switch, an Ethernet switch, or an InfiniBand switch, depending on the communication protocols and bandwidth requirements of the compute node 101 and non-volatile memory devices 100. A PCIe switch can be used to provide direct attachments of the RAID-configured storage devices with the compute node 101. An Ethernet switch may be used to provide network-based connectivity for RAID volumes. An InfiniBand switch may be used to support high-performance data exchanges for RAID configurations. The bus 106 can be one or more of a serial, a PCIe bus or network, a PCIe root complex, an internal PCIe switch, and so on. In some implementations, the switch 107a and/or switch 107b can be integrated into bus 106 such that the suitable interface 140 can support various protocols such as PCIe, Ethernet, and InfiniBand, providing various connectivity options for different storage and processing requirement.

One or more of the non-volatile memory devices 100 can form a RAID array (or group) for parity protection. The RAID group can be distributed across various data nodes 108a-n (collectively referred to herein as "data nodes 108"). That is, one or more of the non-volatile memory devices 100 store parity data (e.g., parity bits) for data stored on those devices and/or data stored on other ones of the non-volatile memory devices 100. As shown, the data nodes 108 can include a plurality of non-volatile memory devices 100a-n. Additionally, the data nodes 108 can include a switch 109 configured to facilitate data routing to non-volatile memory devices 100 of the data node.

Data nodes 108 can contain non-volatile memory devices 100a-n configured for data storage and retrieval. In some implementations, one or more of the non-volatile memory devices 100 can perform operations on data segments of RAID configurations. For instance, the one or more of the non-volatile memory devices 100 can calculate parity bits (e.g., P parity bit, Q parity bit) for RAID configurations using XOR operations and Galois Field arithmetic. In some implementations, a subset of the non-volatile memory devices 100 can store and manage P and Q parity bits.

One or more of the non-volatile memory devices 100 within each data node can calculate intermediate partial P and Q parity bits. The RAID array can be distributed across various data nodes 108a-n, each configured to perform parity calculations. That is, one or more of the non-volatile memory devices 100 perform XOR operations using local data segments and Galois Field arithmetic to produce intermediate partial parity bits. As shown, a storage device of each data node 108 can contribute to the overall parity calculation by processing these intermediate results, which can be exposed to a storage device to perform final XOR operations. In some implementations, one or more storage devices within a node of the RAID volume can perform final XOR operations on the intermediate parity bits to determine the final partial P and Q parity bits. For instance, storage device 100a of data node 108a may perform XOR operations on a portion of data of a stripe stored in storage devices 100a-n of data node 108a. In this instance, the storage device 100a may also retrieve intermediate partial parity bit computations (e.g., of the other portions of data of the stripe) from exposed buffers (e.g., CMBs) of storage device 100b of data node 108b and storage device 100c of data node 108c. The exposed buffers can include the intermediate partial parity bit from the XOR operation of the respective data node.

In some implementations, retrieving can include interfacing with the storage devices using switch 109 and/or switches 107a-b. In some implementations, at least one of the data nodes 108a-n can include a parity device (or parity storage device) that stores parity information. For instance, non-volatile memory device (DP) 100p may manage, store, and update partial P parity bits and non-volatile memory device (DQ) 100q may manage, store, and update partial P parity bits. That is, at least one of the XOR operations performed by the storage nodes can include XORing the partial P parity bit and/or partial Q parity bit (e.g., stored in flash memory of the non-volatile memory device). For instance, at least one of the non-volatile memory devices 100 can retrieve intermediate parity bits from multiple data nodes 108a-n, perform XOR operations on the intermediate parity bits to determine partial parities, and store them in dedicated parity devices.

In some implementations, the non-volatile memory devices 100 within a platform are connected to a Top of Rack (TOR) switch (e.g., switch 109) and can communicate with each other via the TOR switch or another suitable intra-platform communication mechanism. Switch 109 may be a PCIe switch, an Ethernet switch, an InfiniBand switch, or any suitable networking switch. In some implementations, at least one router may facilitate communications among the storage devices in different platforms, racks, or cabinets via a suitable networking fabric (e.g., fiber channel, Multiprotocol Label Switching (MPLS), or any scalable network architecture). That is, the data nodes 108 can be different platforms, racks, or cabinets where switches 109 that can communicate across nodes using PCIe, Ethernet, InfiniBand, or any suitable. For instance, the communication between the data nodes 108 using switches 109 can be using interface 140 (e.g., switches 107a-b). In some implementations, communications from non-volatile memory device 100a of data node 108a can be routed to non-volatile memory device 100b of data node 108n using switches 109 of each data node 108a-b and using interface 140. Examples of the non-volatile memory devices 100 (also referred to herein as "storage devices") include non-volatile devices such as but are not limited to, an SSD, a Non-Volatile Dual In-line Memory Module (NVDIMM), a Universal Flash Storage (UFS), a Secure Digital (SD) device, and so on.

Switch 109, in some implementations configured as a Top of Rack (TOR) switch within data nodes 108, manages data and parity traffic between storage devices. This switch supports protocols for data integrity and RAID process alignment. That is, switch 109 can routes communications across storage devices internal or external to a specific rack or cabinet using a suitable networking fabric. For instance, the RAID array (or group) can include one or more dedicated non-volatile memory devices 100. For example, non-volatile memory device (DP) 100p can store the P parity bit (partial), for example in a memory array. That is, the non-volatile memory device (DP) 100p can facilitate updates, expose parity information to other non-volatile memory devices 100, and perform recalculations. In another example, non-volatile memory device (DQ) 100q can store the Q parity bit (partial), for example in a memory array. That is, the non-volatile memory device (DQ) 100q can facilitate updates, expose parity information to other non-volatile memory devices 100, and perform recalculations. While non-volatile memory devices (e.g., the NAND flash memory devices 130a-130n) are presented as examples herein, the disclosed schemes can be implemented on any storage system or device that is connected to the compute node 101 over an interface, where such system temporarily or permanently stores data for the compute node 101 for later retrieval. The dedicated non-volatile memory devices for managing and storing the P and Q parity bits can be referred to herein as "parity drives."

In some implementations, the P parity bit (partial) can be used in the RAID array or group shown to provide single parity, which can facilitate the recovery from the failure of a single drive (e.g., non-volatile memory device 100a-n). The P parity bit can be calculated by performing an XOR (exclusive OR) operation across corresponding bits of data across multiple drives (e.g., non-volatile memory device 100a-n) by one or more of the non-volatile memory devices 100. This parity information can then be stored on a separate, dedicated non-volatile memory device within the RAID array, for example in non-volatile memory device (DP) 100p (e.g., P parity drive). Thus, the P parity bit can facilitate the reconstruction of missing data when one drive fails. In some implementations, non-volatile memory device (DP) 100p can store parity bits calculated from the XOR operation across the data bits of the other non-volatile memory devices 100. Additionally, when compute node 101 performs a write operation to the non-volatile memory devices 100 in the RAID array, the P parity can be recalculated to reflect the new data. The recalculation can also be performed using an XOR operation. In some implementations, the XOR operation can be performed by one or more of the non-volatile memory devices 100.

In some implementations, the Q parity bit (partial) can be used in the RAID array or group shown to provide double parity, which can facilitate the recovery from the failure of two drives (e.g., non-volatile memory device 100a-n). The Q parity bit can be calculated by performing an XOR (exclusive OR) operation using a Galois coefficient across corresponding bits of data across multiple drives (e.g., non-volatile memory device 100a-n) by one or more of the non-volatile memory devices 100. That is, the Galois coefficient may be determined using Galois Field (GF) arithmetic, which provides a second layer of redundancy. For instance, the Galois coefficient can be a power of two, used in the polynomial representation of Galois Field (GF) arithmetic. This parity information can then be stored on a separate, dedicated non-volatile memory device within the RAID array, for example in non-volatile memory device (DQ) 100q (e.g., q parity drive). Thus, the Q parity bit can facilitate the reconstruction of missing data when two drives fail. In some implementations, non-volatile memory device (DQ) 100q can store parity bits calculated from the XOR operation using a Galois coefficient across the data bits of the other non-volatile memory devices 100. Additionally, when compute node 101 performs a write operation to the non-volatile memory devices 100 in the RAID array, the Q parity can be recalculated to reflect the new data. The recalculation can also be performed using an XOR operation and a Galois coefficient. In some implementations, the XOR operation can be performed by one or more of the non-volatile memory devices 100.

In a read operation by non-volatile memory devices 100 within a RAID array, non-volatile memory device 100a of data node 108a can access data exposed by non-volatile memory device 100b of data node 108n. The process can be facilitated by interactions and communications through switches 109 and 107a-b. For instance, when a read request is issued from non-volatile memory device 100a to access data from non-volatile memory device 100b, the request first is transmitted to the local switch 109 within data node 108a. This switch 109, which may be configured as a PCIe, Ethernet, or InfiniBand switch (e.g., based on the data throughput and latency requirements), can route the request to the corresponding switch in data node 108n via the network infrastructure. As the request reaches data node 108n, switch 109 can direct the read operation to the target non-volatile memory device 100b. In some implementations, the routing between switches 109 in data nodes 108a and 108n can utilize interface 140. The switches 107a-b of interface 140 can manage the intra-node communication. The switches 107a-b can facilitate the transmission of data and can prioritize traffic as necessary to maintain data integrity and minimize latency between the non-volatile memory devices 100 and between a non-volatile memory device and compute node 101.

The processor 104 can execute an Operating System (OS), which provides a filesystem and applications which use the filesystem. The processor 104 can communicate with the non-volatile memory devices 100 (e.g., a controller 110 of each of the non-volatile memory devices 100) via a communication link or network (e.g., switches 107a-b and/or switch 109). In that regard, the processor 104 can send data to and receive data from one or more of the non-volatile memory devices 100 using the interface 140 (e.g., switches 107a-b) and switch 109 of the data node 108 to the application 103 via communication link or network. The interface 140 allows the software (e.g., the filesystem) running on the processor 104 to communicate with the non-volatile memory devices 100 (e.g., the controllers 110 thereof) via the bus 106. The non-volatile memory devices 100 (e.g., the controllers 110 thereof) are operatively coupled to the bus 106 directly via the interface 140. While the interface 140 is conceptually shown as a dashed line between the compute node 101 and the non-volatile memory devices 100, the interface 140 can include one or more controllers, one or more physical connectors, one or more data transfer protocols including namespaces, ports, transport mechanism, and connectivity thereof. For example, interface 140 can be the switches 107a and 107b as shown. While the connection between the compute node 101 and the non-volatile memory devices 100a,..., n, is shown as link through various switches (e.g., switches 107a-b and switch 109), in some implementations the link may be direct or include a network fabric which may include networking components such as bridges and/or additional switches.

To send and receive data, the processor 104 (the software or filesystem run thereon) communicates with the non-volatile memory devices 100 using a storage data transfer protocol running on the switches 107a and 107b. Examples of the protocol include but is not limited to, the SAS, Serial ATA (SATA), and NVMe protocols. In some examples, the switches 107a and 107b include hardware (e.g., controllers) implemented on or operatively coupled to the bus 106, the non-volatile memory devices 100 (e.g., the controllers 110), or another device operatively coupled to the bus 106 and/or the non-volatile memory device 100 via one or more suitable networks. The switches 107a and 107b and the routing protocol running thereon can include software and/or firmware executed on such hardware. Additionally, switch 109 and the routing protocol running thereon can include software and/or firmware executed on such hardware.

In some examples the processor 104 can communicate, via the bus 106. Applications 103 and other compute node (host) systems (not shown) attached or communicably coupled to a communication network can communicate with the compute node 101 using a suitable network storage protocol, examples of which include, but are not limited to, NVMe over Fabrics (NVMeoF), iSCSI, Fibre Channel (FC), Network File System (NFS), Server Message Block (SMB), and so on. The network interface of compute node 101 allows the software (e.g., the storage protocol or filesystem) running on the processor 104 to communicate with the external applications 103 and external hosts attached to one or more communication networks via the bus 106. In this manner, network storage commands may be issued by the external hosts and processed by the processor 104, which can issue storage commands to the non-volatile memory devices 100 as needed. Data can thus be exchanged between the external hosts and the non-volatile memory devices 100 via interface 140. In this example, any data exchanged is buffered in the memory 102 of the compute node 101.

In some examples, the non-volatile memory devices 100 are located in a datacenter (not shown for brevity). The datacenter may include one or more platforms, each of which supports one or more storage devices (such as but not limited to, the non-volatile memory devices 100). As shown, the non-volatile memory devices 100 can be distributed across data nodes 108a-n. In some implementations, the storage devices within a platform are connected to a Top of Rack (TOR) switch (e.g., switch 109) and can communicate with each other via the TOR switch or another suitable intra-platform communication mechanism. In some implementations, one or more non-volatile memory devices 100 together form a storage node, with the compute node 101 acting as a node controller (e.g., compute node) of the storage nodes (e.g., data nodes 108a-n). An example of a storage node is a Kioxia Kumoscale storage node. One or more storage nodes within a platform are connected to switch 109, each storage node connected to switch 109 via one or more network connections, such as a wired or wireless connection, Ethernet, Fiber Channel or InfiniBand, and can communicate with each other via switch 109 or another suitable intra-platform communication mechanism.

In some implementations, non-volatile memory devices 100 may be network attached storage devices (e.g. Ethernet SSDs) connected to switch 109, with compute node 101 also connected to the switch 109 (e.g., via interface 140) and able to communicate with the non-volatile memory devices 100 via switch 109. In some implementations, at least one router may facilitate communications among the non-volatile memory devices 100 in storage nodes in different platforms, racks, or cabinets via a suitable networking fabric. Examples of the non-volatile memory devices 100 include non-volatile devices such as but are not limited to, Solid State Drive (SSDs), Ethernet attached SSDs, a Non-Volatile Dual In-line Memory Modules (NVDIMMs), a Universal Flash Storage (UFS), a Secure Digital (SD) devices, and so on.

In some examples, the switches 107a, 107b (e.g., PCIe) can include at least one of one or more controllers, one or more physical connectors, one or more data transfer protocols including namespaces, one or more ports, one or more switches, one or more bridges, one or more transport mechanisms, connectivity thereof, and so on. The switches 107a, 107b (e.g., PCIe) can create transaction requests for operation tasks of the processor 104 and send the same to the non-volatile memory devices 100 via the bus 106 according to the addresses of the non-volatile memory devices 100 on the bus 106. In some examples, the switches 107a, 107b (e.g., PCIe) can be implemented on the hardware (e.g., chip) of the processor 104. In some examples, the switches 107a, 107b (e.g., PCIe) and the bus 106 can be collectively referred to as the interface 140 between the host processor 104/memory 102 and the non-volatile memory devices 100 of data nodes 108a-n (collectively referred to herein as "data nodes 108").

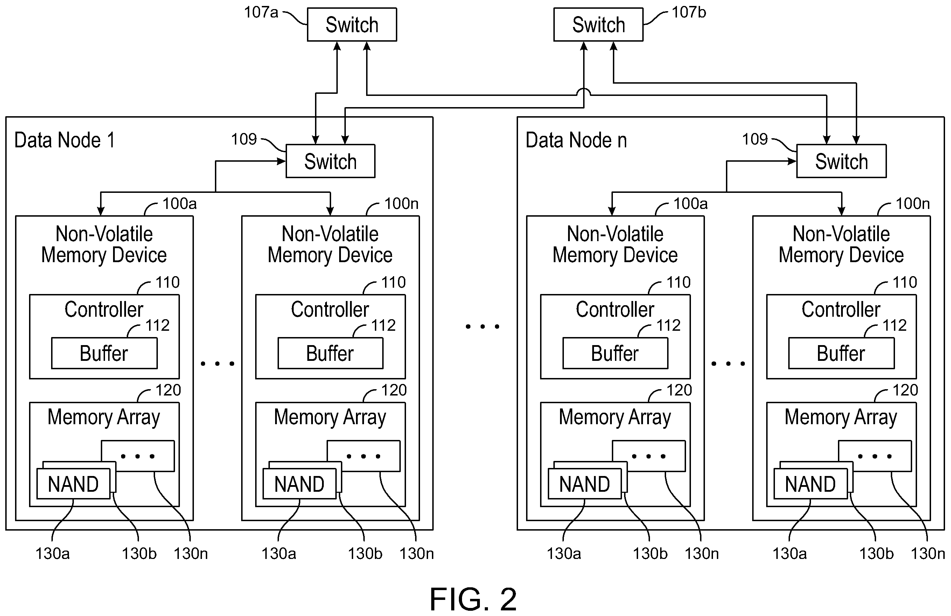

Referring now to FIG. 2, a block diagram further illustrating the example system including non-volatile memory devices and the data nodes, according to some implementations. The non-volatile memory devices 100 (e.g., non-volatile memory device 100a, ..., 100n of data node 1, to non-volatile memory device 100a, ..., 100n of data node n) can include at least a controller 110 and a memory array 120. Other components of the non-volatile memory devices 100 are not shown for brevity. The memory array 120 includes NAND flash memory devices 130a-130n. Each of the NAND flash memory devices 130a-130n includes one or more individual NAND flash dies, which are NVM capable of retaining data without power. Thus, the NAND flash memory devices 130a-130n refer to multiple NAND flash memory devices or dies within the flash memory device 100. Each of the NAND flash memory devices 130a-130n includes one or more dies, each of which has one or more planes. Each plane has multiple blocks, and each block has multiple pages.

While the NAND flash memory devices 130a-130n are shown to be examples of the memory array 120, other examples of non-volatile memory technologies for implementing the memory array 120 include but are not limited to, non-volatile (battery-backed) DRAM, Magnetic Random Access Memory (MRAM), Phase Change Memory (PCM), Ferro-Electric RAM (FeRAM), and so on. The arrangements described herein can be likewise implemented on memory systems using such memory technologies and other suitable memory technologies.

Examples of the controller 110 include but are not limited to, a SSD controller (e.g., a client SSD controller, a datacenter SSD controller, an enterprise SSD controller, and so on), a UFS controller, or an SD controller, and so on. The controller 110 can combine raw data storage in the plurality of NAND flash memory devices 130a-130n such that those NAND flash memory devices 130a-130n function logically as a single unit of storage. The controller 110 can include processors, microcontrollers, a buffer memory (e.g., buffer 112), error correction systems, data encryption systems, Flash Translation Layer (FTL) and flash interface modules. Such functions can be implemented in hardware, software, and firmware or any combination thereof. In some arrangements, the software/firmware of the controller 110 can be stored in the memory array 120 or in any other suitable computer readable storage medium.

The controller 110 can include suitable processing and memory capabilities for executing functions described herein, among other functions. As described, the controller 110 manages various features for the NAND flash memory devices 130a-130n including but not limited to, parity checking, parity computations, I/O handling, reading, writing/programming, erasing, monitoring, logging, error handling, garbage collection, wear leveling, logical to physical address mapping, data protection (encryption/decryption, Cyclic Redundancy Check (CRC)), Error Correction Coding (ECC), data scrambling, and the like. Thus, the controller 110 provides visibility to the NAND flash memory devices 130a-130n.

The buffer 112 can include buffer memory. The buffer memory can be a memory device local to, and operatively coupled to, the controller 110. For instance, the buffer memory can be an on-chip SRAM memory located on the chip of the controller 110. In some implementations, the buffer memory can be implemented using a memory device of the storage device 110 external to the controller 110. For instance, the buffer memory of buffer 112 can be DRAM located on a chip other than the chip of the controller 110. In some implementations, the buffer memory can be implemented using memory devices both internal and external to the controller 110 (e.g., both on and off the chip of the controller 110). For example, the buffer memory can be implemented using both an internal SRAM and an external DRAM, which are transparent/exposed and accessible by other devices via the interface 140, such as the compute node 101 and other non-volatile memory devices 100. In this example, the controller 110 includes an internal processor that uses memory addresses within a single address space and the memory controller, which controls both the internal SRAM and external DRAM, selects whether to place the data on the internal SRAM and an external DRAM based on efficiency. In other words, the internal SRAM and external DRAM are addressed like a single memory. The buffer memory of the buffer 112 can include write buffers, read buffers, Controller Memory Buffers (CMBs), and so on.

As shown, the controller 110 includes a buffer 112, which is sometimes referred to as a drive buffer or a Controller Memory Buffer (CMB). Besides being accessible by the controller 110, the buffer 112 is accessible by other devices via the interface 140, such as the compute node 101 and other non-volatile memory devices 100a, 100b, ... 100n. In that manner, the buffer 112 (e.g., addresses of memory locations within the buffer 112) is exposed across the bus 106, and any device operatively coupled to the bus 106 can issue commands (e.g., read commands, write commands, and so on) using addresses that correspond to memory locations within the buffer 112 in order to read data from those memory locations within the buffer and write data to those memory locations within the buffer 112. In some examples, the buffer 112 is a volatile storage. In some examples, the buffer 112 is a non-volatile persistent storage, which may offer improvements in protection against unexpected power loss of one or more of the non-volatile memory devices 100. Examples of the buffer 112 include but are not limited to, RAM, DRAM, SRAM, MRAM, PCM, and so on. The buffer 112 may refer to multiple buffers each configured to store data of a different type, as described herein.

In some implementations, as shown in FIG. 1, the buffer 112 is a local memory of the controller 110. For instance, the buffer 112 can be an on-chip SRAM memory located on the chip of the controller 110. In some implementations, the buffer 112 can be implemented using a memory device of the storage device 110 external to the controller 110. For instance, the buffer 112 can be DRAM located on a chip other than the chip of the controller 110. In some implementations, the buffer 112 can be implemented using memory devices both internal and external to the controller 110 (e.g., both on and off the chip of the controller 110). For example, the buffer 112 can be implemented using both an internal SRAM and an external DRAM, which are transparent/exposed and accessible by other devices via the interface 140, such as the compute node 101 and other non-volatile memory devices 100. In this example, the controller 110 includes an internal processor uses memory addresses within a single address space and the memory controller, which controls both the internal SRAM and external DRAM, selects whether to place the data on the internal SRAM and an external DRAM based on efficiency. In other words, the internal SRAM and external DRAM are addressed like a single memory.

In one example concerning a write operation, in response to receiving data from the compute node 101 (via the host interface 140), the controller 110 acknowledges the write commands to the compute node 101 after writing the data to a write buffer of buffer 112. In some implementations the write buffer may be implemented in a separate, different memory than the other buffers of buffer 112, or the write buffer may be a defined area or part of a shared memory, where only the CMB part of the memory is accessible by other devices, but not the write buffer. The controller 110 can write the data stored in the write buffer to the memory array 120 (e.g., the NAND flash memory devices 130a-130n). Once writing the data to physical addresses of the memory array 120 is complete, the FTL updates mapping between logical addresses (e.g., Logical Block Address (LBAs)) used by the compute node 101 to associate with the data and the physical addresses used by the controller 110 to identify the physical locations of the data. In another example concerning a read operation, the controller 110 includes a read buffer different from the write buffer 112 and the CMB buffer to store data read from the memory array 120. In some implementations the read buffer may be implemented in a separate, different memory than the other buffers of buffer 112, or the read buffer may be a defined area or part of a shared memory, where only the CMB part of the memory is accessible by other devices, but not the read buffer.

During start up, switch 107a and/or switch 107b can scan the bus 106 for any attached devices (e.g., physically connected or connected via a network such as a network fabric) and obtain the device addresses of the non-volatile memory devices 100 (e.g., routing scans through switch 109 of data nodes), the processor 104, and the memory 102. In some examples, the switches 107a, 107b (e.g., PCIe) scans the bus 106 also for the buffer 112 on the non-volatile memory devices 100. The non-volatile memory devices 100, the buffers 112, and the memory 102 can each be assigned an address space within the logical address space of the processor 104. In some examples, SLM and PMR namespaces can be used for addressing the buffers 112. Accordingly, the processor 104 can perform operations such as read and write using the logical address space. The addresses of the buffers 112 are therefore exposed to the processor 104 and the non-volatile memory devices 100. Other methods of exposing the addresses of the buffers 112, such as memory map (e.g., memory-mapped Input/Output (I/O) space) can be likewise implemented. The memory-mapped I/O space allows any memory coupled to the bus 106 to be mapped to an address recognizable by the processor 104.

Traditionally, to update parity data (or parity) on a parity drive in a RAID 5 or 6 group, 2 read I/O operations, 2 write I/O operations, 4 transfers over the bus 106, and 4 memory buffer transfers are needed. All such operations require CPU cycles, Submission Queue (SQ)/Completion Queue (CQ) entries, Context Switches, and so on, on the processor 104. In addition, the transfer performed between the processor 104 and the memory 102 consume buffer space and bandwidth between the processor 104 and the memory 102. Still further, the communication of data between the processor 104 and the bus 106 consume bandwidth of the bus 106, where the bandwidth of the bus 106 is considered a precious resource because the bus 106 serves as an interface among the different components of the compute node 101. Accordingly, traditional parity update schemes consume considerable resources (e.g., bandwidth, CPU cycles, and buffer space) on the compute node 101.

In a memory device such as a RAID array, configuring one disk to hold the parity bits of corresponding data stored on some number of other disks allows for the data on said other disks to be reconstructed using the parity bits, should one or more such other disk fail. Parity bits (e.g., P parity bit and/or Q parity bit) can be calculated by applying exclusive-or (XOR) operations to two or more data sets. Table 1 demonstrates an example of the possible results of a two-bit input XOR parity operation in which the parity operation output is a 0 if the input bits are different, and is a 1 if the input bits are the same.

Table 1 Exemplary XOR Parity Results

| Inputs | | Parity Output |
|---|---|---|
| 0 | 0 | 1 |
| 0 | 1 | 0 |
| 1 | 0 | 0 |
| 1 | 1 | 1 |

Using parity calculations performed as such, one of the inputs can be recovered based on the other input and the parity bit. For example, based on Table 1, if it is known that a first input to the parity calculation is a '0', and that resultant parity bit is a '1', then it can be determined that the second input to the parity calculation was a '0'. In this manner, parity calculations allow for lost inputs to be recovered and provide redundancy.

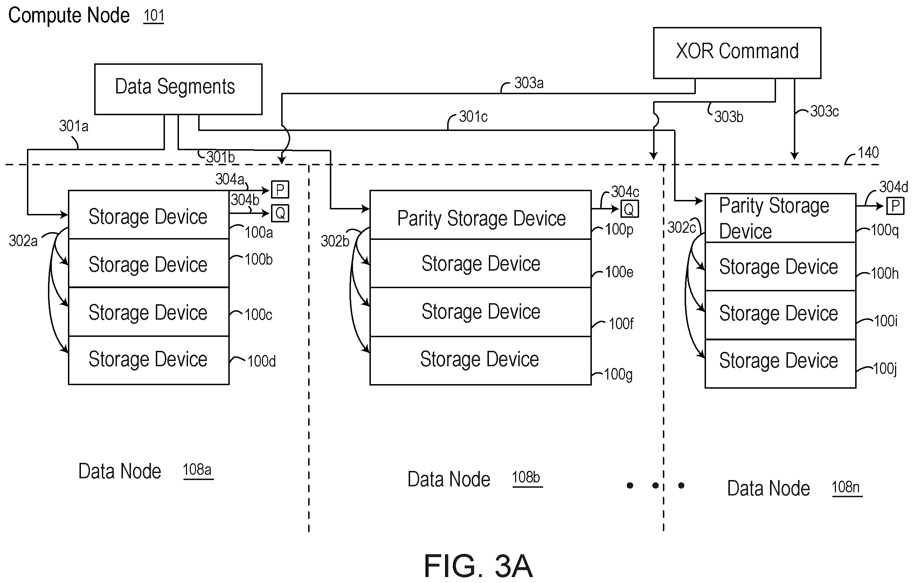

Referring to FIGS. 3A-3D, decoupling of parity calculations may be performed by a controller of a non-volatile memory device, such as storage device 100a. In order to perform parity calculations, servers currently pay a heavy cost in terms of DRAM bandwidth, CPU usage, and performance when performing parity calculations (and other operations, including erasure code computation, data compression and decompression, and encryption). A typical server connected to an array of SSDs, however, may have 8 to 48 connected SSDs (e.g., storage devices). Because a typical server may be connected to 8 to 48 SSDs, the server may have insufficient bandwidth to perform parity calculations, relative to the SSDs.

According to an embodiment of the present disclosure, the controller (e.g., controller 110 of FIG. 2) of each SSD (e.g., non-volatile memory devices 100) can determine parity information for data stored across a plurality of SSDs. Further, the controller of each SSD can also be configured to output the parity information to parity drives of the RAID group, across data nodes. Some or more of the components described in detail in FIGS. 1-2 such as compute node 101, and the particular data nodes 108 and switches 107 are not illustrated in FIGS. 3A-3D for the sake of brevity. However, it should be understood that various operations including storing, reading, writing, retrieving, and exposing described in FIGS. 3A-3D can be facilitated through the use of switch 109 of the various data nodes 108 and switches 107 according to above.

The controller of storage device 100a may be configured to receive data segments and perform XOR operations, and thus serve as an XOR engine. In general, any additional data processing unit (DPU) in communication with the compute node (e.g., computer node 101 of FIGS. 1 and 2) may also perform the parity bit calculations. Regardless of the component of the system to which the parity calculations are offloaded, the RAID array or group will benefit from freed-up bandwidth as the parity bit calculations are offloaded to the XOR engines of storage devices. As described, the method 350 provides improved I/O efficiency, host CPU efficiency, and memory resource efficiency as compared to the conventional data and parity update methods. The method 350 can be performed by storage device 100a or any other non-volatile memory device 100a-n of the various data nodes 108a-n. When the compute node 101 provides new data segments to the storage devices 100, parities can be determined to maintain data redundancy and ensure data integrity. If discrepancies between recalculated and stored parity are detected (e.g., non-zero XOR output), the new parity can indicate potential data corruption or a parity error, prompting the controller 110 or compute node 101 to either correct the data using the existing parity or to update the erroneous parity.

As will be shown, the XOR result from the CMB (e.g., buffer 112) of the controller (e.g., controller 110) of the storage devices is not transferred across the interface 140 into the host 101. Instead, the transient XOR result in the CMB can be directly transferred to a parity drive (e.g., the storage device 100p) to perform a final parity computation (e.g., XORing a plurality of intermediate parities) and update the parity data corresponding to the updated, new data segments. The direct transfer can be facilitated using switch 109 and/or switches 107a-b. Furthermore, parity storage device 100p and parity storage device 100q (e.g., both non-volatile memory devices of a RAID array or group) can be designated to perform parity computations and store parity data corresponding to the data stored on the other storage devices 100a-n. For instance, storage device 100p may determine and store P parity data and storage device 100q may determine and store Q parity data. However, the parity data may be stored in NAND of a memory array (e.g., memory array 120).

Referring now to FIG. 3A, FIG. 3A is a block diagram illustrating an example method for performing offloading, according to some implementations. The compute node 101 (e.g., host) can submit new data from application 103. The host 101 presents the data segments to storage devices and/or parity storage devices to be written. For instance, a host buffer of the host 101 can present one or more data segments to a controller (e.g., controller 110) of various storage devices (e.g., devices 100a, 100p, and 100q). While FIG. 3A depicts configurations of storage devices 100a-n including parity storage devices 100p and 100q in various data nodes 108a-n, it should be understood various configurations are also contemplated herein. For instance, data node 108a may include 8 storage devices (e.g., SSD1-SSD8), data node 108b may include an additional 8 storage devices (e.g., SSD9-SSD16), and data node 108n may include 6 storage devices (e.g., SSD17-SSD22), parity storage device 100p, and parity storage device 100q. Thus, the various operations, transfers, updates, writes, reads, and so on described herein may be added, removed, or updated according to the specific RAID array or group configuration.

Generally, the compute node 101 can transfer multiple data segments to control memory buffers (CMBs) of various storage devices of the RAID array or group. For instance, the compute node 101 can provide storage device 100 four data segments (e.g., a segment for each storage device of the data node), parity storage device 100p three data segments, and parity storage device 100q three data segments. A 10+2 RAID configuration is shown (not limited to) which can include ten data disks and two parity disks. The data disks and parity disks can be distributed across various data nodes 108a-n. In some implementations, the transfer of data segments to the CMBs can occur during write operations, parity calculations, and data reconstruction processes in the RAID array or group.

At step 301a, a set of the data segments may be provided to storage device 100a. The set of data segments may be D1 data segment, D2 data segment, D3 data segment, and D4 data segment (e.g., for each corresponding storage device of data node 108b). In some implementations, controller 110 of storage device 100a may perform a data transfer to obtain the set of the data segments (regular, non-parity data) from the compute node 101 (e.g., from a host buffer) through the bus 106 across the interface 140 via the one or more switches, and store the new set of the data segments into a device buffer of the controller of storage device 100a. Generally, the devices buffers described herein can be CMBs. For instance, the transfer from compute node 101 and NANDs can be facilitated using a copybuf command. That is, the copybuf command or another transfer command may be used by the controller 110 of storage device 100a to pull or access data from the buffers and/or NAND devices into the device buffers (e.g., CMBs) of controller 110.

At step 301b, another set of the data segments may be provided to parity storage device 100a. The set of data segments may be D5 data segment, D6 data segment, and D7 data segment (e.g., for each corresponding storage device of data node 108b). In some implementations, controller 110 of storage device 100p may perform a data transfer to obtain the set of the data segments (regular, non-parity data) from the compute node 101 (e.g., from a host buffer) through the bus 106 across the interface 140 via the one or more switches, and store the new set of the data segments into a device buffer of the controller of parity storage device 100p.

At step 301c, another set of the data segments may be provided to parity storage device 100a. The set of data segments may be D8 data segment, D9 data segment, and D10 data segment (e.g., for each corresponding storage device of data node 108n). In some implementations, controller 110 of storage device 100q may perform a data transfer to obtain the set of the data segments (regular, non-parity data) from the compute node 101 (e.g., from a host buffer) through the bus 106 across the interface 140 via the one or more switches, and store the new set of the data segments into a device buffer of the controller of parity storage device 100q.

At step 302a, the controller of storage device 100a can store new data segments by writing the various data segments from a device buffer (e.g., CMB) into NAND pages (new data) 320a-n. A new NAND physical page can be written and a Logical-to-Physical (L2P) address mapping table updated to indicate the new NAND page corresponding to the logical address used by the compute node 101. In some implementations, the controller of storage device 100a may write one or more data segments (e.g., D1) to local NAND pages of storage device 100a. Additionally, the controller of storage device 100a can write one or more data segments (e.g., D2-D4) to other storage devices of data node 108a. For instance, the controller of storage device 100a can write data segment D2 to storage device 100b, data segment D3 to storage device 100c, and data segment D4 to storage device 100d within data node 108a. In this instance, the controller 110 of each respective storage device 100b-d updates their own L2P address mapping tables to reflect the new data segments' physical locations. The writing can be facilitated over switch 109 and/or switches 107a-b. In some implementations, the controller 110 can write the data stored in the CMB to the memory array 120 (e.g., the NAND flash memory devices 130a-130n) of the various storage devices of data node 108a (e.g., storage devices 100a-d). Once writing the data to physical addresses of the memory array 120 is complete, the Flash Translation Layer (FTL) updates mapping between logical addresses (e.g., Logical Block Address (LBAs)) used by the host 101 to associate with the data and the physical addresses used by the controller 110 to identify the physical locations of the data. While non-volatile memory devices (e.g., the NAND flash memory devices 130a-n) are presented as examples herein, the disclosed schemes can be implemented on any storage system or device that is connected to the host 101 over an interface, where such system temporarily or permanently stores data for the host 101 for later retrieval. In some implementations, steps 302a-c can occur, during or after steps 303-304.

At step 302b, the controller of parity storage device 100p can store new data segments by writing the various data segments from a device buffer (e.g., CMB) into NAND pages (new data) 320a-n. In some implementations, the controller of parity storage device 100p can write one or more data segments (e.g., D5-D7) to other storage devices of data node 108b. That is, while parity storage device 100p can include a controller and buffers to perform various computations and actions, the parity storage device 100p may only store parity information in the NAND pages of parity storage device 100p. As shown, the parity storage device 100p can instead store the new data segments into the other storage devices 100e-g of data node 108b. For instance, the controller of parity storage device 100p can write data segment D5 to storage device 100e, data segment D6 to storage device 100f, and data segment D7 to storage device 100g within data node 108b. In this instance, the controller 110 of each respective storage device 100e-g updates their own L2P address mapping tables to reflect the new data segments' physical locations. The writing can be facilitated over switch 109 and/or switches 107a-b. In some implementations, the controller 110 can write the data stored in the CMB to the memory array 120 (e.g., the NAND flash memory devices 130a-130n) of the various storage devices of data node 108b (e.g., storage devices 100eg).

At step 302c, the controller of parity storage device 100q can store new data segments by writing the various data segments from a device buffer (e.g., CMB) into NAND pages (new data) 320a-n. In some implementations, the controller of parity storage device 100q can write one or more data segments (e.g., D8-D10) to other storage devices of data node 108n. That is, while parity storage device 100q can include a controller and buffers to perform various computations and actions, the parity storage device 100q may only store parity information in the NAND pages of parity storage device 100q. As shown, the parity storage device 100q can instead store the new data segments into the other storage devices 100h-j of data node 108n. For instance, the controller of parity storage device 100q can write data segment D8 to storage device 100h, data segment D9 to storage device 100i, and data segment D10 to storage device 100j within data node 108n. In this instance, the controller 110 of each respective storage device 100h-j updates their own L2P address mapping tables to reflect the new data segments' physical locations. The writing can be facilitated over switch 109 and/or switches 107a-b. In some implementations, the controller 110 can write the data stored in the CMB to the memory array 120 (e.g., the NAND flash memory devices 130a-130n) of the various storage devices of data node 108b (e.g., storage devices 100h-j).

In some implementations, at step 303a-c, the compute node 101 can send an XOR command to calculate partial parities in each data node 108a-n. The XOR command can be routed via bus 106 over interface 140 to the data nodes 108a-n. For instance, switch 109 may receive the XOR command and route the command to a designated storage device (e.g., storage devices 100a, p, and q). In some implementations, the command can include parameters such as the memory addresses of the data segments to be included in the XOR calculation, the target buffers for storing the intermediate partial parities, and any relevant metadata for synchronization. The compute node 101 transmits this command over the interface 140, which can include switches 107a-b and switch 109, providing each designated storage device controller the instruction to perform the XOR operations on the specified data segments (previously received). In some implementations, the XOR command may be sent with the data segments at steps 301a-c. For instance, the compute node 101 may issue a DMA command to transfer data segments directly into the CMBs of the storage devices while concurrently sending the XOR command. In this instance, the storage devices can immediately begin the XOR operations upon receiving the data segments.

At steps 304a-d, the controller of a respective storage device of data nodes 108a-n can perform one or more XOR operations between data (e.g., non-parity data and/or parity data-if parity devices are storage devices of the data node of controller 110) stored in the CMBs to determine one or more XOR results, and store the XOR results in one or more device buffers. That is, the XOR results can occur between source buffers (e.g., one source buffer if the buffer stores all the data segments, or multiple buffers if the buffers store one data segment or portions of data segments) and one or more output buffers (e.g., one buffer if one intermediate parity is determined-parity storage device 100p and parity storage device 100q, two buffers if two intermediate parities are determined-storage device 100a). In some implementations, the XOR operations can occur on a portion of a stripe of the data segments of the RAID group. The data segments can be a stripe including data D1, D2, ... Dn, of the various storage devices spanning the RAID array according to what data segments were provided by the compute node 101 to what storage devices. For instance, a data segment can include data of D1, D2, ... Dn. In this instance, a first controller of a first storage device (e.g., storage device 100a) of a first data node (e.g., data node 108a) may perform XOR operations on data D1-D4 to determine first intermediate parity data (e.g., Pnode1 and Qnode1). In another instance, a second controller of a second storage device (e.g., parity storage device 100p) of a second data node (e.g., data node 108b) may perform XOR operations on data D5-D7 to determine intermediate parity data (e.g., Pnode2 and Qnode2). In yet another instance, a third controller of a third storage device (e.g., parity storage device 100q) of a third data node (e.g., data node 108n) may perform XOR operations on data D8-D10 including parity device P and parity device Q to determine intermediate parity data (Pnode3 and Qnode3). In some implementations, a single XOR operation can be performed such that intermediate parity data can reflect both the P and Q parity. For instance, the data segments stored in the device buffers of controller 110 can be used as input into an XOR operation to determine an intermediate partial parity, where both P and Q parity computations can be performed in the single XOR operation (e.g., PQnode1, PQnode2 ... PQnoden).

In some implementations, an XOR operation performed by controller 110 of a storage device of a data node can be (Equation 1):

$$Intermediate\ Partial\ Parity\ Bit\ P\ (Pnode1\_byte1)$$

$$= D1\_byte1 \oplus D2\_byte1 ... \oplus Dn\_byte1$$

where $\oplus$ is an XOR operation, D1-Dn is data of a stripe stored on a storage device (e.g., SSD). The XOR operation can occur on each bite of the data segment.

In some implementations, an XOR operation performed by controller 110 of a storage device of a data node can be (Equation 2):

$$Intermediate\ Partial\ Parity\ Bit\ Q\ (Qnode1\_byte1)$$

$$= (g1 * D1\_byte1) \oplus (g2 * D2\_byte1) ... \oplus (gn * Dn\_byte1)$$

where $\oplus$ is an XOR operation, D1-Dn is data of a stripe stored on a storage device (e.g., SSD), and g1-gn are Galois coefficients. The XOR operation can occur on each bite of the data segment.

In some implementations, the XOR operation (combining the XOR operations) performed by controller 110 of a storage device of a data node can be (Equation 3):

$$Intermediate\ Partial\ Parity\ Bit\ PQ\ (PQnode1\_byte1)$$

$$= D1\_byte1 \oplus D2\_byte1 ... \oplus Dn\_byte1 \oplus (g1 * D1\_byte1)$$

$$\oplus (g2 * D2\_byte1) ... \oplus (gn * Dn\_byte1)$$

In some implementations, at step 304a, the controller may output a sequence of XOR results such as, Pnode1 = [XOR_byte1, XOR_byte2, ... XOR_byte(n)]. At step 304b, the controller may output Qnode1 = [XOR_byte1, XOR_byte2, ... XOR_byte(n)]. At step 304c, the controller may output Qnode2 = [XOR_byte1, XOR_byte2, ... XOR_byte(n)]. At step 304d, the controller may output Pnode3 = [XOR_byte1, XOR_byte2, ... XOR_byte(n)]. That is, parity storage device 100p can determine Pnode2 and store the results in a CMB to perform the final parity computation-based on what is retrieved or transmitted to parity storage device 100p (e.g., Pnode1 and Pnode3). Furthermore, parity storage device 100q can determine Qnode3 and store the results in a CMB to perform the final parity computation-based on what is retrieved or transmitted to parity storage device 100q (e.g., Qnode1 and Qnode3).

As shown, the XOR (exclusive OR) operations can be applied to the corresponding bytes from each data segment to produce the parity byte. For example, in data segments D1, D2, D3, ..., Dn, and storage device 100a is performing an XOR operation to obtain an intermediate partial P parity, the first byte of the intermediate partial P parity is determined by XORing the first byte of D1, the first byte of D2, the first byte of D3, ..., the first byte of Dn. In this example, the second byte of the intermediate partial P parity is determined by is calculated by XORing the second byte of D1, the second byte of D2, the second byte of D3, ..., the second byte of Dn. This process continues for each byte position in the stripe. In some implementations, each byte of Pnode and Qnode can be provided to the parity storage devices for computation of a final parity.

In some implementations, the controller 110 can perform XOR operations on data from stripe 1 to stripe n. As shown, the intermediate partial parity (e.g., parity bit P and parity bit Q) can be determined separately using separate XOR operations (Equations 1-2) or determined in combination using a single XOR operation (Equation 3). In some implementations, when separate operations occur, the intermediate partial parity data may be stored into separate CMBs. In some implementations, when separate operations occur, the intermediate partial parity data may be stored into a single CMB of controller 110. In some implementations, when one operation occurs, the intermediate partial parity data may be stored in a single CMB of controller 110.

At steps 304a-d, the controller of a respective storage device of data nodes 108a-n can also transmit or expose the intermediate partial parity data to other storage devices of the RAID array or group. That is, the XOR results can be exposed to another controller to perform final parity computation or other XOR results (e.g., other intermediate partial parity computations) can be retrieved by controller 110 to perform final parity computation. That is, intermediate partial parity data can be directly transferred or exposed to other storage devices of the RAID array or group. For example, at step 304a the intermediate partial P parity byte set can be exposed to parity storage device 100p. In another example, at step 304a the intermediate partial P parity byte set can be transmitted to parity storage device 100p via an interface (e.g., PCIe switch 109). The exposing and transmitting can occur on all the storage devices that performed the XOR operations. In some implementations, the parity storage devices 100p and 100q may store the intermediate partial parity in a CMB (e.g., instead of exposing or transmitting) to perform a final parity computation.

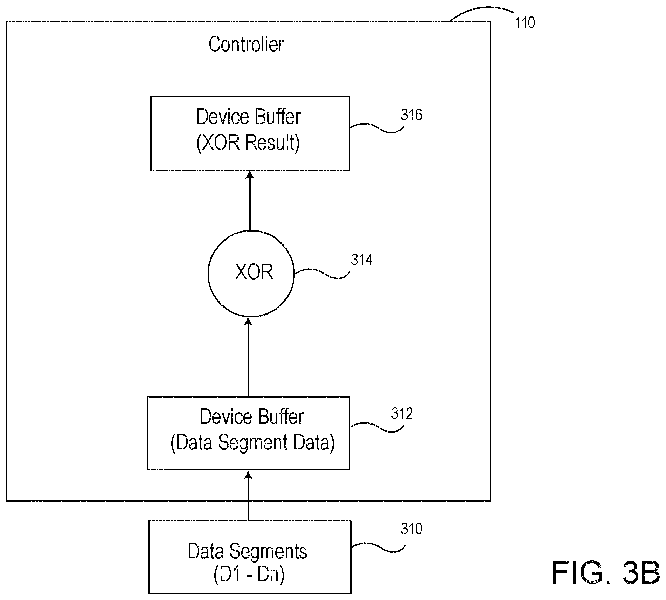

Referring now to FIG. 3B is a block diagram illustrating an example method for performing one or more parity checks on a data node using a controller of a storage device, according to some implementations. As will be shown, the XOR result from the CMB (e.g., buffer 112) of the controller 110 of the storage device 100 is not transferred across the interface 140 into the host 101. Instead, intermediate XOR results in the CMB can be exposed to other storage devices of other data nodes 108a-n. Furthermore, the final XOR results (e.g., XORing the intermediate XOR results) in the CMB can be directly stored in a parity drive (e.g., the storage device 100p and 100q) to update the parity data. Furthermore, storage device 100p can be designated to store parity data corresponding to the data stored on the other storage devices 100an. In some implementations, another storage device 100q can be designated to store parity data corresponding to the data stored on other storage devices 100a-n. New data storage operations can include performing a parity check can be performed. Generally, the devices buffers 312 and 316 can be CMBs. For instance, the transfer of data segments from the compute node 101 can be facilitated using a copybuf command. That is, the copybuf command or another transfer command may be used by the controller 110 of the storage device 100 to pull or access data from the compute node 101 (e.g., data segments 310) into the device buffers (e.g., CMBs) of controller 110. The command can include a logical address (e.g., LBA) of the new data.

The controller 110 of the storage device performs a store (or write) into a device buffer (data segment data) 312. The controller 110 can interface with other storage devices connected to a specific switch 109 (e.g., PCIe switch). That is, the other storage devices of the specific switch 109 can form a data node. For instance, the data node can include storage devices D1-D8. In some implementations, the controller 110 of the storage device can receive data segments (D1-Dn) 310 and store them into one or more device buffers (data segment data) 312. In some implementations, the data segments 310 can be read into a single buffer.

At 314, the controller 110 can perform one or more XOR operations between data (e.g., non-parity data) stored in the CMBs-device buffer 312-to determine one or more XOR results, and store the XOR results in device buffer (XOR result) 316. That is, the XOR results can occur between one source buffer and one output buffer. The XOR operation can occur on byte-by-byte of the data segments. In some implementations, the XOR operations can occur on a portion of a stripe of the data segments of the RAID group. The data segments 310 can be a stripe including data D1, D2, ... Dn. For instance, a data segment can include data of D1, D2, ... Dn. In this instance, a first controller of a first storage device of a first data node may perform XOR operations on data D1-D8 to determine first intermediate parity data, Pnode1 (of all bytes) and Qnode1 (of all bytes). In another instance, a second controller of a second storage device of a second data node may perform XOR operations on data D9-D16 to determine intermediate parity data, Pnode2 and Qnode2. In yet another instance, a third controller of a third storage device of a third data node may perform XOR operations on data D17-D22 to determine intermediate parity data, Pnode3 and Qnode3. In some implementations, a single XOR operation can be performed such that intermediate parity data can reflect both the P and Q parity (in a byte-by-byte output). For instance, the device buffers of controller 110 can be used as input into an XOR operation to determine an intermediate partial parity, where both P and Q parity computations can be performed in the single XOR operation (e.g., PQnode1, PQnode2 ... PQnoden).

In some implementations, one or more XOR operations 314 are shown in Equations 1-3. In some implementations, the controller 110 can perform XOR operations on data from stripe 1 to stripe n of data segment 310. As shown, the intermediate partial parity (e.g., parity bit P and parity bit Q) can be determined separately using separate XOR operations or determined in combination using a single XOR operation. In some implementations, when separate operations occur, the intermediate partial parity data may be stored into separate CMBs. In some implementations, when one operation occurs, the intermediate partial parity data may be stored in a single CMB (e.g., device buffer (XOR result) 316) of controller 110.

In some implementations, device buffer (XOR result) 316 can be a particular implementation of a CMB of controller 110. In other implementations, to conserve memory resources, the CMB can be the same as the device buffer 312 and is a particular implementation of the buffer 112 of the storage device, such that the XOR results can be written over the content of the device buffer 312. The one or more XOR results from device buffer (XOR result) 316 (e.g., in a CMB) is not transferred across the interface 140 into the compute node 101. Instead, the XOR results can be exposed to another controller to perform final parity computation or other XOR results (e.g., other intermediate partial parity computations) can be retrieved by controller 110 to perform final parity computation. That is, intermediate partial parity data can be directly transferred or exposed to other storage devices of the RAID array or group. Additionally, final parity data in the device buffers can be directly transferred to a parity drive to update the parity data. For instance, the controller 110 can temporarily store the one or more XOR result in device buffer (XOR result) 316 after determining the XOR results.

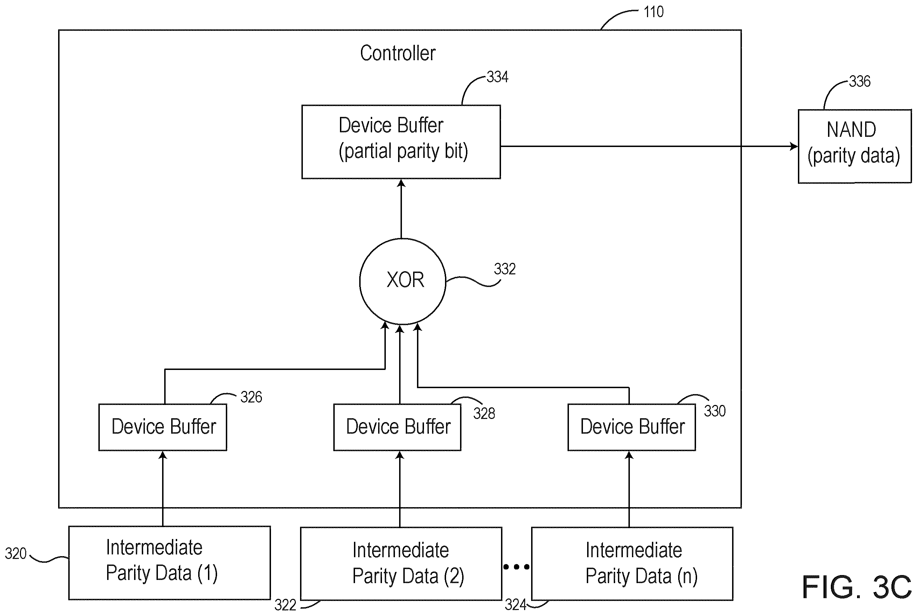

Referring now to FIG. 3C, a block diagram illustrating an example method for performing one or more parity checks across data nodes using a controller of a storage device, according to some implementations. Generally, the devices buffers 326-330 can be CMBs. For instance, the transfer from CMBs of the data nodes can be facilitated using a copybuf command. That is, the copybuf command or another transfer command may be used by the controller 110 of the storage device 100 to pull or access data from the buffers of other storage devices into the device buffers (e.g., CMBs) of controller 110. The read request can include a logical address (e.g., LBA) of the intermediate partial parity data. In some implementations, controller 110 can be the controller of parity storage device 100p and/or parity storage device 100q of FIG. 3A.

As described in detail with reference to FIG. 3A, one or more controllers of each data node of the plurality of data nodes can perform XOR operations to determine one or more intermediate partial parity bits. Now in FIG. 3C, controller 110 of a storage device of a particular node can perform the final partial parity operations. A parity check can be initiated by one or more controllers of various data nodes. That is, one or more controllers of the non-volatile memory devices 100 perform XOR operations to compute intermediate partial parity bits. As shown, this process includes receiving data segments from the compute node 101 and applying XOR operations to generate intermediate partial P and Q parity bits (or bytes). Additionally, the intermediate parity results can be exposed to controllers at other data nodes through the use of switch 109. Furthermore, controller 110 can retrieve these intermediate parity results (e.g., locally from a CMB or externally from a CMB of other controllers) to determine final partial parity bits. For instance, additional XOR operations on these intermediate results can be performed by controller 110, using switch 109 and/or switches 107a-b for data transfer of the intermediate partial parity bits. This process can update the parity data and stores it in dedicated parity devices within the RAID array, as described.

Generally, the controllers of the storage devices can include device buffers (e.g., device buffers 312, 316 of FIG. 3B and device buffers 326-330 and 334 of FIG. 3C), which is sometimes referred to as a drive buffer or a CMB. Besides being accessible by the controller 110, the devices buffers can be accessible by other devices via switch 109 and/or switches 107a-b, such as other storage devices 100a, 100b, ... 100n and parity storage devices 100p and 100q. In that manner, the device buffers (e.g., addresses of memory locations within the buffer) can be exposed across the switch 109 and/or switches 107a-b, and any device operatively coupled to the switch 109 and/or switches 107a-b can issue commands (e.g., read commands, write commands, store commands, retrieve commands, and so on) using addresses that correspond to memory locations within the device buffer (e.g., of controllers of storage devices on data nodes) in order to read data from those memory locations within the buffer and write data to locations within a buffer of controller 110.

For instance, Pnode1 and Pnode3 data (e.g., intermediate parity bit data) can be exposed by a controller of storage devices of data node 1 and 3 (e.g., storage device 100a and parity storage device 100q) such that controller 110 of parity storage device 100p (e.g., of data node 108b) can read the exposed intermediate parity bit data (e.g., byte-by-byte package of parities) via one or more interfaces (e.g., switch 109 and/or switches 107a-b) into device buffers 326-330. That is, the parity storage devices described herein may be part of different data nodes, but may also be part of the same data node. The Pnode and Qnode data can be exposed to the parity storage devices irrespective of the data nodes the parity storage devices are operatively coupled to. In another instance, Qnode1 and Qnode2 data (e.g., intermediate parity bit data) can be exposed by a controller of storage devices of data node 1 and 2 (e.g., storage device 100a and parity storage device 100p) such that controller 110 of parity storage device 100q (e.g., of data node 108n) can read the exposed intermediate parity bit data (e.g., byte-by-byte package of parities) via one or more interfaces (e.g., switch 109 and/or switches 107a-b) into device buffers 326-330. For instance, intermediate parity data (1) 320 can be read into device buffer 326. In another instance, intermediate parity data (2) 322 can be read into device buffer 328. In yet another instance, intermediate parity data (3) 324 can be read into device buffer 330.

As described above, a first controller (e.g., controller 110) of a first storage device of a first data node of the RAID volume can perform a first intermediate partial P and Q parity computation, which can stored in one or more device buffers . Furthermore, a second controller of a second storage device of a second data node of the RAID volume can perform a second intermediate partial P and Q parity computation, which can stored in one or more device buffers. As shown, it should be appreciated each data node can include at least one controller that performs intermediate parity computations, and at least one controller of the plurality of data storages of the RAID volume can perform the partial parity bit computations (e.g., partial P parity bit, and partial Q parity bit). The controller 110 of the storage device of FIG. 3C can perform buffer reads into device buffers 326-330. That is, device buffer 326 may already include stored intermediate partial parity data (e.g., intermediate partial P parity data) determined by controller 110 of parity storage device 100p. However, in some implementations, a different controller that did not perform any of the intermediate partial parity computations may be used. The buffer read can be of all buffers storing the intermediate parity data. That is, one or more storage devices of the nodes may be designed as intermediate parity calculation devices. The read can be a buffer read command (e.g., direct memory access (DMA) command) to read or fetch intermediate parity data stored in the exposed buffers of one or more storage devices. For instance, the buffer read command allows for accessing data directly from the device buffers where intermediate parity data is stored. That is, this facilitates data access across different controllers and data nodes without additional processing. The buffer read command can include a logical address (LBA) that specifies the location of the data with the buffers. For instance, when intermediate parity bits are calculated and stored, the corresponding logical block addresses (LBAs) can be updated or flagged in a way that indicates to controller 110 when the intermediate calculations were performed. In another instance, controller 110 can determine the LBA of a buffer of a controller of another node that performed the XOR operations by accessing synchronized mapping tables shared among controllers. In yet another instance, controller 110 can determine the LBA of a buffer of a controller of another node that performed the XOR operations by decoding updates communicated through the RAID volume's internal network protocol

The data stored in device buffers can be from storage devices 100 of other data nodes (e.g., data node 108b-n). The reads of remote buffer data of a data node of the controller 110 can be facilitated using switch 109 (e.g., PCIe switch). For example, data transfers across these devices can be managed through the internal networking fabric. In this example, switch 109 may be a fabric bridge or router, facilitating direct, PCIe communications between storage devices within and across different data nodes. Additionally, the reads of remote buffer data of another data node can be facilitated using switch 109 and one or more of switches 107a-b. In other words, the controller 110 of the data storage can read the intermediate partial parity data, corresponding to the logical address in the device buffers. The controller 110 can then store intermediate parity data (1) 320 in device buffer 326, intermediate parity data (2) 322 in device buffer 328, and intermediate parity data (3) 324 in device buffer 330. In some implementations, the controller 110 may route various intermediate partial parity data to different devices buffers. It should be appreciated that controller 110 may also store all the Pnode or Qnode data (e.g., depending on the parity storage device) in a single device buffer or in a designed device buffer. As shown, the controller 110 of the storage device can performs buffer reads into device buffers 328-330 from the external data nodes (e.g., where intermediate parity data (1) 320 may have already been stored in a device buffer based on the parity storage device performing an XOR operation on data segments provided by the compute node 101). The buffer read can be of all the computed intermediate partial parity bits stored in CMBs of the RAID group or array (e.g., non-volatile memory devices 100).

At 332, the controller 110 performs one or more XOR operations between data (e.g., intermediate partial parity information) stored in the CMBs-device buffers 326-330-to determine one or more XOR results, and stores the XOR results in device buffer (partial parity bit) 334. That is, the XOR results can occur between three source buffers and one output buffer. In some implementations, the XOR operations can occur be of a stripe of the data segments of the RAID group. The data segments-represented in the intermediate partial parity bits-can be a stripe including data D1, D2, ... Dn of the data segments. For instance, a XOR Pnode (e.g., performed by parity storage device 100p) can be a partial P parity check of a data segment including data of D1, D2, ... Dn. In another instance, a XOR Qnode (e.g., performed by parity storage device 100q) can be a partial Q parity check of a data segment including data of D1, D2, ... Dn, and parity Q (partial).

In these instances, a first controller of a first storage device of a first data node may perform XOR operations on data D1-D4 to determine first intermediate parity data, Pnode1 and Qnode1. In another instance, a second controller of a second storage device of a second data node may perform XOR operations on data D5-D7 including parity storage device P to determine intermediate parity data, Pnode2 and Qnode2. In yet another instance, a third controller of a third storage device of a third data node may perform XOR operations on data D8-D10 including parity storage device Q to determine intermediate parity data, Pnode3 and Qnode3. In XOR operation 332, the intermediate parity data can be XORed (e.g., byte-by-byte). For instance, the local and remote Pnode data of the device buffers 326-330 of controller 110 can be used as input into an XOR operation to determine a final partial parity, where the P parity computation can be performed in the single XOR operation (e.g., Pnode).

In some implementations, XOR operation 332 performed by controller 110 of parity storage device 100p of a data node can be (Equation 4):

$$Partial\ Parity\ Bit\ P\ (XOR\ Pnode)$$

$$= Pnode1\_byte1 \oplus Pnode2\_byte1 \ldots \oplus Pnoden\_byte1 \oplus Pnode1\_byte2$$

$$\oplus Pnode2\_byte2 \ldots \oplus Pnoden\_byte2 \ldots Pnoden\_byte(n)$$

where $\oplus$ is an XOR operation until n bytes, Pnode1-n is intermediate partial parity data of data nodes (e.g., having a plurality of storage devices and computed by a controller of one or more of the plurality of storage devices).

In some implementations, XOR operation 332 performed by controller 110 of parity storage device 100q of a data node can be (Equation 5):

$$Partial\ Parity\ Bit\ Q\ (XOR\ Qnode)$$

$$= Qnode1\_byte1 \oplus Qnode2\_byte1 \ldots \oplus Qnoden\_byte1 \oplus Qnode1\_byte2$$

$$\oplus Qnode2\_byte2 \ldots \oplus Qnoden\_byte2 \ldots Qnoden\_byte(n)$$

where $\oplus$ is an XOR operation until n bytes, and Qnode1-n were calculated using data of the data segments and Galois coefficients.

In some implementations, the controller 110 can perform XOR operations on data from stripe 1 to stripe n. As shown, the partial parity bits (e.g., parity bit P and parity bit Q) can be determined separately using separate XOR operations (Equations 4-5) or determined in combination using a single XOR operation (Equation 10). In some implementations, the partial parity data may be stored into separate CMBs of separate parity storage devices-parity storage device 100p and parity storage device 100q.

In some implementations, device buffer (partial parity bit) 334 can be a particular implementation of a CMB of controller 110. In other implementations, to conserve memory resources, the CMB can be the same as the device buffers 326-330 and is a particular implementation of the buffer 112 of the storage device, such that the XOR results can be written over the content of the device buffers 326-330.The one or more XOR results from device buffer (partial parity bit) 334 (e.g., in a CMB) is not transferred across the interface 140 into the compute node 101. Instead, the XOR results can be stored in the NAND of the parity storage devices 100p and 100q. That is, partial parity data can be directly written to the RAID array or group of non-volatile memory device (DP) 100p and/or non-volatile memory device (DQ) 100q by controller 110. That is, final parity data in the device buffer 334 can be directly written to the NAND of the parity storage devices. Writing the one or more XOR results to the non-volatile storage includes writing the XOR result to a second physical address of the non-volatile storage (e.g., at the NAND page) and updating L2P mapping to correspond the logical address to the second physical address. The writing can be facilitated over switch 109 and/or switches 107a-b.

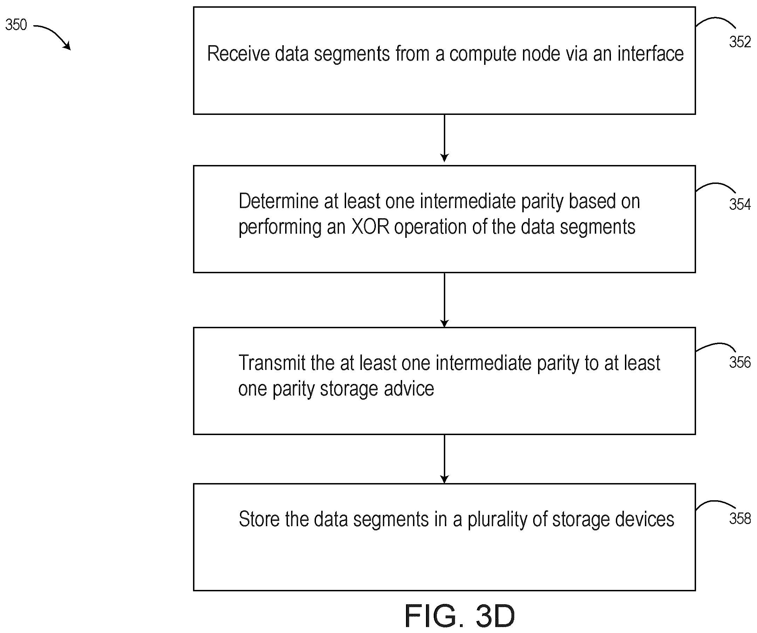

FIG. 3D is a flowchart illustrating an example method for performing operations on data segments, according to some implementations

Referring now to FIG. 3D, a flowchart illustrating an example method for performing operations on data segments, according to some implementations. Referring to FIGS. 1, 2, and 3A-3C, method 350 corresponds to FIG. 3A-3C. Method 350 can be performed by the controller of one or more storage devices 100.

In broad overview of method 480, in a RAID configuration, multiple data nodes with storage devices can be implemented. For example, a compute node could transfer four new data segments to the CMB of SSD1 in data node 1, three new data segments to the CMB of SSDp (p parity) in data node 2, and three new data segments to the CMB of SSDq (q parity) in data node 3. Furthermore, in this example, the compute node can issue XOR commands to each SSD (e.g., that received the data segments) to calculate the intermediate P and Q parities. That is, the SSDs can perform the XOR operations on the received data segments and stores the intermediate parities in its CMB. The intermediate parities may be transmitted to the parity storage devices (e.g., SSDp and SSDq) which can calculate the final P parity, final Q parity. In some implementations, the final P and Q parities can be written to the non-volatile memory of SSDp and SSDq, respectively. Additionally, the new data segments can be written to new physical locations in the non-volatile memory of the respective SSDs in data node 1, data node 2, and data node 3.

In general, from a non-parity storage device implementation, the controller of a storage device can receive a plurality of data segments from a compute node via an interface. In some implementations, the controller can store the plurality of data segments in at least one device buffer of the first storage device. Furthermore, the controller can determine at least one intermediate parity based on performing at least one XOR operation on a byte-by-byte basis of the plurality of data segments, the at least one intermediate parity being stored in the at least one device buffer of the first storage device. Additionally, the controller can transmit the at least one intermediate parity from the at least one device buffer to at least one parity storage device. That is, the at least one intermediate parity can correspond to one of a plurality of intermediate parities used to determine at least one partial parity of a redundant array of independent disk (RAID) volume. In some implementations, the controller can store the plurality of data segments in new physical locations in the first non-volatile memory and a second non-volatile memory of a second storage device.

Furthermore, from a parity storage device implementation, the controller of the parity device can receive at least one intermediate parity from a first storage device via an interface. The at least one intermediate parity can be stored in at least one device buffer of the parity storage device. In some implementations, the controller can determine at least one partial parity based on performing at least one XOR operation on a byte-by-byte basis of the at least one intermediate parity and additional intermediate parities received from a plurality of storage devices of the RAID volume. Furthermore, the controller can store the at least one partial parity in the non-volatile memory of the parity storage device. The at least one partial parity can be used to maintain data redundancy and integrity in the RAID volume.

At block 352, the controller of a first storage device can receive a plurality of data segments from a compute node via an interface. The data segment can be received over a bus over the interface. In some implementations, the first storage device can be one of a plurality of storage devices of a first data node of a plurality of data nodes of the RAID volume. That is, the first storage device can be one of a set of storage devices of the plurality of data nodes. For instance, each of the set of storage devices is a solid-state drive (SSD) in communication with the compute node via the interface. In some implementations, the plurality of data segments is received according to a direct memory access (DMA) command issued by the compute node. For instance, the compute node can issue a DMA command specifying the memory addresses of the data segments to be transferred to the control memory buffers (CMBs) of the storage device. The controller of the first storage device can then processes the DMA command to directly transfer the data segments from the compute node into the CMBs. In some implementations, in response to receiving the plurality of data segments, the controller can perform a store operation to store the plurality of data segments to one or more controller memory buffers (CMBs) of the controller.

At block 354, the controller can determine at least one intermediate parity based on performing at least one XOR operation of the plurality of data segments. The at least one intermediate parity can be stored in at least one device buffer of the first storage device. In some implementations, the at least one intermediate parity can include an intermediate partial P parity bit and an intermediate partial Q parity bit of the plurality of data segments. In some implementations, the controller can receive an XOR command from the compute node via the interface. That is, determining the at least one intermediate parity can be in response to receiving the XOR command. In some implementations, in response to determining the at least one intermediate parity, the controller can store the at least one intermediate parity in the one or more CMBs of the controller. In some implementations, the at least one device buffer can be the one or more CMBs of the controller. In some implementations, the at least one intermediate parity can be a parity bit set determined byte-by-byte using the at least XOR operation on each byte of the plurality of data segments (e.g., Equations 1-2).

In some implementations, when the first storage device is the parity storage device (e.g., parity storage device 100p and/or 100q) the controller can determine a first intermediate parity based on performing a first XOR operation of the plurality of data segments. That is, the parity storage device corresponding with the first intermediate parity (e.g., parity storage device 100p corresponding with partial P parity and parity storage device 100q corresponding with partial Q parity) can store the first intermediate parity in at least one device buffer of the first parity storage device (e.g., local). In some implementations, the parity storage device can determine a second intermediate parity based on performing a second XOR operation of the plurality of data segments. That is, the second intermediate parity being stored in the at least one device buffer of the first parity storage device. That is, the parity not corresponding with the parity storage device can be transmitted. For instance, the controller can transmit the second intermediate parity of the at least one device buffer to a second parity storage device;

At block 356, the controller can transmit the at least one intermediate parity of the at least one device buffer to at least one parity storage device. That is, the at least one intermediate parity can correspond to one of a plurality of intermediate parities used to determine at least one partial parity of a redundant array of independent disk (RAID) volume. In some implementations, the at least one parity storage device can correspond to a second data node of the plurality of data nodes. That is, the first storage device and the at least one parity storage device can be operatively coupled via the interface. In some implementations, the transmission of the at least one intermediate parity to the at least one parity storage device can include transmitting the at least one intermediate parity to one or more remote CMBs of a remote controller of the at least one parity storage device (e.g., controller of parity storage device 100p and/or 100q)

At block 358, the controller can store the plurality of data segments in at least the first storage device and a second storage device. In some implementations, the data segments can be stored/written to NAND. That is, storing can include performing a first write operation to write a first portion (e.g., D1) of the plurality of data segments to the first non-volatile memory of the first storage device and performing a second write operation to write a second portion (e.g., D2) of the plurality of data segments to a second non-volatile of the second storage device. In some implementations, when the controller is the controller of one of the parity storage devices, the controller of the parity storage device can store the plurality of data segments in at least a first storage device and a second storage device (e.g., external in NAND of other storage devices of the data node of the parity storage device).

In some implementations, the parity storage device controller can receive at least one third intermediate parity from at least one third storage device of a redundant array of independent disk (RAID) volume. For instance, the at least one third intermediate parity can correspond to at least the first intermediate parity (e.g., both intermediate partial P parities or both intermediate partial Q parities). In some implementations, the parity storage device controller can determine at least one partial parity based on performing at least one XOR operation of at least the first intermediate parity and the at least one third intermediate parity. Additionally, the parity storage device controller can store the at least one partial parity in the non-volatile memory, the at least one partial parity corresponds to a set of data segments.

When the parity storage device is the controller the first intermediate parity can be a first parity bit set determined byte-by-byte using the first XOR operation on each byte of the plurality of data segments and the second intermediate parity can be a second parity bit set determined byte-by-byte using the second XOR operation on each byte of the plurality of data segments. In some implementations, the first parity storage device can correspond to a partial P parity computation device of the RAID volume and the second parity storage device can correspond to a partial Q parity computation device of the RAID volume. For instance, the second intermediate parity can be an intermediate partial Q parity bit set. In some implementations, the first parity storage device can correspond to a partial Q parity computation device of the RAID volume and the second parity storage device can correspond to a partial P parity computation device of the RAID volume. For instance, the second intermediate parity can be an intermediate partial P parity bit set. In some implementations, the first parity storage device can be one of a plurality of storage devices of a first data node of a plurality of data nodes of the RAID volume. Additionally, the first storage device can be one of a set of storage devices of the plurality of data nodes and each of the set of storage devices is a solid-state drive (SSD) in communication with the compute node via the interface. In some implementations, the set of data segments can include the plurality of data segments received from the compute node and an additional data segments provided by the compute node to the plurality of data nodes. In some implementations, the plurality of storage devices of the first data node further includes the first storage device and the second storage device. For instance, the second parity storage device can be one of a second plurality of storage devices of a second data node of the plurality of data nodes of the RAID volume.

The previous description is provided to enable any person skilled in the art to practice the various aspects described herein. Various modifications to these aspects will be readily apparent to those skilled in the art, and the generic principles defined herein may be applied to other aspects. Thus, the claims are not intended to be limited to the aspects shown herein, but is to be accorded the full scope consistent with the language claims, wherein reference to an element in the singular is not intended to mean "one and only one" unless specifically so stated, but rather "one or more." Unless specifically stated otherwise, the term "some" refers to one or more. All structural and functional equivalents to the elements of the various aspects described throughout the previous description that are known or later come to be known to those of ordinary skill in the art are expressly incorporated herein by reference and are intended to be encompassed by the claims. Moreover, nothing disclosed herein is intended to be dedicated to the public regardless of whether such disclosure is explicitly recited in the claims. No claim element is to be construed as a means plus function unless the element is expressly recited using the phrase "means for."

It is understood that the specific order or hierarchy of steps in the processes disclosed is an example of illustrative approaches. Based upon design preferences, it is understood that the specific order or hierarchy of steps in the processes may be rearranged while remaining within the scope of the previous description. The accompanying method claims present elements of the various steps in a sample order, and are not meant to be limited to the specific order or hierarchy presented.

The previous description of the disclosed implementations is provided to enable any person skilled in the art to make or use the disclosed subject matter. Various modifications to these implementations will be readily apparent to those skilled in the art, and the generic principles defined herein may be applied to other implementations without departing from the spirit or scope of the previous description. Thus, the previous description is not intended to be limited to the implementations shown herein but is to be accorded the widest scope consistent with the principles and novel features disclosed herein.

The various examples illustrated and described are provided merely as examples to illustrate various features of the claims. However, features shown and described with respect to any given example are not necessarily limited to the associated example and may be used or combined with other examples that are shown and described. Further, the claims are not intended to be limited by any one example.

The foregoing method descriptions and the process flow diagrams are provided merely as illustrative examples and are not intended to require or imply that the steps of various examples must be performed in the order presented. As will be appreciated by one of skill in the art the order of steps in the foregoing examples may be performed in any order. Words such as "thereafter," "then," "next," etc. are not intended to limit the order of the steps; these words are simply used to guide the reader through the description of the methods. Further, any reference to claim elements in the singular, for example, using the articles "a," "an" or "the" is not to be construed as limiting the element to the singular.

The various illustrative logical blocks, modules, circuits, and algorithm steps described in connection with the examples disclosed herein may be implemented as electronic hardware, computer software, or combinations of both. To clearly illustrate this interchangeability of hardware and software, various illustrative components, blocks, modules, circuits, and steps have been described above generally in terms of their functionality. Whether such functionality is implemented as hardware or software depends upon the particular application and design constraints imposed on the overall system. Skilled artisans may implement the described functionality in varying ways for each particular application, but such implementation decisions should not be interpreted as causing a departure from the scope of the present disclosure.

The hardware used to implement the various illustrative logics, logical blocks, modules, and circuits described in connection with the examples disclosed herein may be implemented or performed with a general purpose processor, a DSP, an ASIC, an FPGA or other programmable logic device, discrete gate or transistor logic, discrete hardware components, or any combination thereof designed to perform the functions described herein. A general-purpose processor may be a microprocessor, but, in the alternative, the processor may be any conventional processor, controller, microcontroller, or state machine. A processor may also be implemented as a combination of computing devices, e.g., a combination of a DSP and a microprocessor, a plurality of microprocessors, one or more microprocessors in conjunction with a DSP core, or any other such configuration. Alternatively, some steps or methods may be performed by circuitry that is specific to a given function.

In some exemplary examples, the functions described may be implemented in hardware, software, firmware, or any combination thereof. If implemented in software, the functions may be stored as one or more instructions or code on a non-transitory computer-readable storage medium or non-transitory processor-readable storage medium. The steps of a method or algorithm disclosed herein may be embodied in a processor-executable software module which may reside on a non-transitory computer-readable or processor-readable storage medium. Non-transitory computer-readable or processor-readable storage media may be any storage media that may be accessed by a computer or a processor. By way of example but not limitation, such non-transitory computer-readable or processor-readable storage media may include RAM, ROM, EEPROM, FLASH memory, CD-ROM or other optical drive storage, magnetic drive storage or other magnetic storages, or any other medium that may be used to store desired program code in the form of instructions or data structures and that may be accessed by a computer. Drive and disc, as used herein, includes compact disc (CD), laser disc, optical disc, digital versatile disc (DVD), floppy drive, and Blu-ray disc where drives usually reproduce data magnetically, while discs reproduce data optically with lasers. Combinations of the above are also included within the scope of non-transitory computer-readable and processor-readable media. Additionally, the operations of a method or algorithm may reside as one or any combination or set of codes and/or instructions on a non-transitory processor-readable storage medium and/or computer-readable storage medium, which may be incorporated into a computer program product.

The preceding description of the disclosed examples is provided to enable any person skilled in the art to make or use the present disclosure. Various modifications to these examples will be readily apparent to those skilled in the art, and the generic principles defined herein may be applied to some examples without departing from the spirit or scope of the disclosure. Thus, the present disclosure is not intended to be limited to the examples shown herein but is to be accorded the widest scope consistent with the following claims and the principles and novel features disclosed herein.

## Claims

1. A first storage device, comprising:

   a first non-volatile memory; and
   a controller configured to:

   receive a plurality of data segments from a compute node via an interface;
   determine at least one intermediate parity based on performing at least one XOR operation of the plurality of data segments, the at least one intermediate parity being stored in at least one device buffer of the first storage device;
   transmit the at least one intermediate parity of the at least one device buffer to at least one parity storage device, wherein the at least one intermediate parity corresponds to one of a plurality of intermediate parities used to determine at least one partial parity of a redundant array of independent disk (RAID) volume; and
   store the plurality of data segments in at least the first storage device and a second storage device.

2. The first storage device of claim 1, wherein the controller is further configured to:

   receive an XOR command from the compute node via the interface; and
   wherein determining the at least one intermediate parity is in response to receiving the XOR command.

3. The first storage device of claim 1, wherein storing the plurality of data segments comprises:

   performing a first write operation to write a first portion (D1) of the plurality of data segments to the first non-volatile memory of the first storage device; and
   performing a second write operation to write a second portion (D2) of the plurality of data segments to a second non-volatile of the second storage device.

4. The first storage device of claim 1, wherein:

   the first storage device is one of a plurality of storage devices of a first data node of a plurality of data nodes of the RAID volume;
   the first storage device is one of a set of storage devices of the plurality of data nodes; and
   each of the set of storage devices is a solid-state drive (SSD) in communication with the compute node via the interface.

5. The first storage device of claim 4, wherein:

   the at least one parity storage device corresponds to a second data node of the plurality of data nodes; and
   the first storage device and the at least one parity storage device operatively coupled via the interface.

6. The first storage device of claim 1, wherein:
   the plurality of data segments is received according to a direct memory access (DMA) command issued by the compute node.

7. The first storage device of claim 1, wherein:
   the at least one intermediate parity comprises an intermediate partial P parity bit and an intermediate partial Q parity bit of the plurality of data segments.

8. The first storage device of claim 1, wherein the controller is further configured to:

   in response to receiving the plurality of data segments, perform a store operation to store the plurality of data segments to one or more controller memory buffers (CMBs) of the controller; and
   in response to determining the at least one intermediate parity, store the at least one intermediate parity in the one or more CMBs of the controller.

9. The first storage device of claim 1, wherein:

   the at least one device buffer is the one or more CMBs of the controller; and
   the transmission of the at least one intermediate parity to the at least one parity storage device comprises transmitting the at least one intermediate parity to one or more remote CMBs of a remote controller of the at least one parity storage device.

10. The first storage device of claim 1, wherein:
    the at least one intermediate parity is a parity bit set determined byte-by-byte using the at least XOR operation on each byte of the plurality of data segments.

11. A first parity storage device, comprising:

    a non-volatile memory; and
    a controller configured to:

        receive a plurality of data segments from a compute node via an interface;
        determine a first intermediate parity based on performing a first XOR operation of the plurality of data segments, the first intermediate parity being stored in at least one device buffer of the first parity storage device;

determine a second intermediate parity based on performing a second XOR operation of the plurality of data segments, the second intermediate parity being stored in the at least one device buffer of the first parity storage device;

transmit the second intermediate parity of the at least one device buffer to a second parity storage device;

store the plurality of data segments in at least a first storage device and a second storage device;

receive at least one third intermediate parity from at least one third storage device of a redundant array of independent disk (RAID) volume, the at least one third intermediate parity corresponds to at least the first intermediate parity;

determine at least one partial parity based on performing at least one XOR operation of at least the first intermediate parity and the at least one third intermediate parity; and

store the at least one partial parity in the non-volatile memory, the at least one partial parity corresponds to a set of data segments.

12. The first parity storage device of claim 11, wherein:

the first intermediate parity is a first parity bit set determined byte-by-byte using the first XOR operation on each byte of the plurality of data segments; and

the second intermediate parity is a second parity bit set determined byte-by-byte using the second XOR operation on each byte of the plurality of data segments.

13. The first parity storage device of claim 11, wherein the first parity storage device corresponds to a partial P parity computation device of the RAID volume and the second parity storage device corresponds to a partial Q parity computation device of the RAID volume, wherein the second intermediate parity is an intermediate partial Q parity bit set.

14. The first parity storage device of claim 11, wherein the first parity storage device corresponds to a partial Q parity computation device of the RAID volume and the second parity storage device corresponds to a partial P parity computation device of the RAID volume, wherein the second intermediate parity is an intermediate partial P parity bit set.

15. The first parity storage device of claim 11, wherein:

the first parity storage device is one of a plurality of storage devices of a first data node of a plurality of data nodes of the RAID volume;

the first storage device is one of a set of storage devices of the plurality of data nodes; and

each of the set of storage devices is a solid-state drive (SSD) in communication with the compute node via the interface.

16. The first parity storage device of claim 15, wherein:
the set of data segments comprise the plurality of data segments received from the compute node and an additional data segments provided by the compute node to the plurality of data nodes.

17. The first parity storage device of claim 15, wherein:

the plurality of storage devices of the first data node further comprise the first storage device and the second storage device; and

the second parity storage device is one of a second plurality of storage devices of a second data node of the plurality of data nodes of the RAID volume.

18. At least one non-transitory processor-readable medium comprising processor-readable instructions, such that, when executed by a processor of a first storage device, causes the processor to:

receive a plurality of data segments from a compute node via an interface;

determine at least one intermediate parity based on performing at least one XOR operation of the plurality of data segments, the at least one intermediate parity being stored in at least one device buffer of the first storage device;

transmit the at least one intermediate parity of the at least one device buffer to at least one parity storage device, wherein the at least one intermediate parity corresponds to one of a plurality of intermediate parities used to determine at least one partial parity of a redundant array of independent disk (RAID) volume; and store the plurality of data segments in at least the first storage device and a second storage device.

19. The non-transitory processor-readable medium of claim 17, wherein the processor is further caused to:

receive an XOR command from the compute node via the interface; and
wherein determining the at least one intermediate parity is in response to receiving the XOR command.

20. The non-transitory processor-readable medium of claim 17, wherein storing the plurality of data segments comprises:

performing a first write operation to write a first portion (D1) of the plurality of data segments to the first non-volatile memory of the first storage device; and
performing a second write operation to write a second portion (D2) of the plurality of data segments to a second non-volatile of the second storage device.

FIG. 1

EP 4 650 965 A2

EP 4 650 965 A2

FIG. 2

Compute Node 101

FIG. 3A

Controller 110

Device Buffer
(XOR Result) 316

XOR 314

Device Buffer
(Data Segment Data) 312

Data Segments
(D1 - Dn) 310

FIG. 3B

FIG. 3C

EP 4 650 965 A2

350

| Receive data segments from a compute node via an interface | 352 |

Determine at least one intermediate parity based on performing an XOR operation of the data segments — 354

Transmit the at least one intermediate parity to at least one parity storage advice — 356

Store the data segments in a plurality of storage devices — 358

FIG. 3D